# EUROPEAN PATENT SPECIFICATION

(11) **EP 2 542 026 B1**
(45) Date of publication and mention of the grant of the patent: **12.06.2019**
(21) Application number: 11783385.5
(22) Date of filing: 28.04.2011
(51) Int. Cl.: H05B 33/08, H01L 51/50, H05B 37/02

(54) **ILLUMINATION DEVICE AND LIGHT-ADJUSTING METHOD**
BELEUCHTUNGSVORRICHTUNG UND LICHTEINSTELLUNGSVERFAHREN
DISPOSITIF D'ÉCLAIRAGE ET PROCÉDÉ DE RÉGLAGE DE LUMIÈRE

(30) Priority: 17.05.2010 JP 2010113147
(43) Date of publication of application: 02.01.2013
(73) Proprietor: Nec Lighting, Ltd., Tokyo 105-0014 (JP)
(72) Inventor: SAKAGUCHI, Yoshikazu, Tokyo 105-0014 (JP)
(74) Representative: Gill, David Alan
(86) International application number: PCT/JP2011/060371
(87) International publication number: WO 2011/145448

(56) References cited:
- EP-A1- 1 734 793
- JP-A- 2001 272 938
- JP-A- 2007 322 457
- US-A1- 2005 168 564

## Description

The present invention relates to an illumination device and light-adjusting method.

An organic EL (ElectroLuminescenct) element is one light-emitting element used in illumination devices. An organic EL element has a thin-film construction. As a result, an organic EL element is prone to the occurrence of variations in film thickness in the fabrication process as well as to the occurrence of variations in electrical characteristics such as current/voltage characteristics or current/luminance characteristics.

When discrepancies in film thickness and electrical characteristics occur among organic EL elements, discrepancies occur in the luminance and chromaticity among the organic EL elements in an illumination device in which the same drive signal is supplied to each of a plurality of organic EL elements. In addition, lengthening of the emission time interval of an organic EL element leads to greater deterioration of the luminance characteristics or the chromaticity characteristics of the organic EL element, and the degree of this deterioration will differ for each organic EL element. As a result, variations in luminance and chromaticity among organic EL elements may become even greater as the emission time interval becomes extended.

Japanese Unexamined Patent Application Publication No. 2008-210588 discloses an illumination device in which variations in the optical output of LEDs (Light Emitting Diodes) are suppressed. The luminous intensity per unit area of optical output is the luminance. The illumination device described in Patent Document 1 is equipped with a plurality of LEDs as the light-emitting elements, a lighting switch that adjusts the amount of current to each LED, and a control unit that controls lighting of the LEDs.

In the illumination device described in Patent Document 1, the control unit uses the lighting switch to change the duty ratio that indicates the supply time of current to each LED per unit time and thus adjust the optical output of each LED.

US2005/168564 discloses an illumination device comprising a plurality of organic EL elements and having reception means that receives, for each of the elements, chromaticity information, and also supply means that, for each of the elements, is arranged to supply a drive signal having an amplitude that accords with the chromaticity information.

The illumination device disclosed in Patent Document 1 is able to use the above-described organic EL elements as the light-emitting elements. In this case, although variations in the luminance among organic EL elements during light emission can be controlled, a problem arises in which variations in chromaticity cannot be suppressed.

It is an object of the present invention to provide an illumination device and light-adjusting method that solve the above-described problem. The invention concerns a device as in claim 1 and a method as in claim 5.

According to one aspect of the present invention there is provided an illumination device comprising: a plurality of organic EL elements; reception means that receives, for each of said organic EL elements, chromaticity information that indicates the chromaticity of the relevant organic EL element and luminance information that indicates the luminance of the relevant organic EL element; and supply means that, for each of said organic EL elements, supplies to the relevant organic EL element a drive signal having an amplitude that accords with the chromaticity that was indicated by the chromaticity information for that organic EL element for, within a unit time interval, a time interval that accords with the luminance indicated by the luminance information for that organic EL element, characterized in that said supply means is arranged to time-divide said unit time interval into a plurality of specific intervals, and supplies said drive signal to said organic EL elements such that the amplitude or the supplying time of said drive signals are different in each specific interval.

According to another aspect of the present invention there is provided a light-adjusting method in an illumination device that has a plurality of organic EL elements, comprising steps of: receiving, for each of said organic EL elements, chromaticity information that indicates chromaticity of a relevant organic EL element and luminance information that indicates luminance of the relevant organic EL element; and for each of said organic EL elements, supplying to the relevant organic EL element a drive signal having amplitude that accords with the chromaticity that was indicated by the chromaticity information for the relevant organic EL element for, within a unit time interval, a time interval that accords with the luminance indicated by the luminance information for the relevant organic EL element and characterized by time-dividing said unit time interval into a plurality of specific intervals; and supplying said drive signal to said organic EL elements such that the amplitude or the supplying time of said drive signals are different in each specific interval.

### Effect of the Invention

According to the present invention, variations in luminance and chromaticity among a plurality of organic EL elements can be suppressed.

### Brief Description of the Drawings

FIG. 1 is a block diagram showing an example of the configuration of the illumination device in an exemplary embodiment of the present invention.
FIG. 2a shows the drive voltage dependence characteristic of chromaticity of a light-emitting panel.
FIG. 2b shows the drive voltage dependence characteristic of color temperature of a light-emitting panel.
FIG. 3a shows the waveform of an amplitude signal that is supplied from the pulse amplitude control unit.
FIG. 3b shows the waveform of a periodic signal that is supplied from the pulse width control unit.
FIG. 3c shows the waveform of a synthesized signal that is supplied from the synthesizing unit.
FIG. 4a shows the waveform of a drive voltage that is supplied from the drive circuit.
FIG. 4b shows an example of supplying a reverse bias voltage to a light-emitting panel during non-emission.
FIG. 5a shows an example of the waveform of the drive current that is supplied to light-emitting panel 111.
FIG. 5b shows an example of the waveform of a drive current that is supplied to light-emitting panel 112.
FIG. 5c shows an example of the waveform of the drive current that is supplied to light-emitting panel 113.
FIG. 5d shows an example of the waveform of the drive current that is supplied to light-emitting panel 114.
FIG. 6 is a flow chart showing an example of the processing procedure of the light-adjusting method of illumination device 100.
FIG. 7a shows an example of a drive signal that is supplied to light-emitting panel 111 in which the amplitude and supply time of the drive signal are altered for each predetermined time interval.
FIG. 7b shows an example of a drive signal that is supplied to light-emitting panel 112 in which the amplitude and supply time of the drive signal are altered for each predetermined time interval.
FIG. 7c shows an example of a drive signal that is supplied to light-emitting panel 113 in which the amplitude and supply time of the drive signal are altered for each predetermined time interval.
FIG. 7d shows an example of a drive signal that is supplied to light-emitting panel 114 in which the amplitude and supply time of the drive signal are altered for each predetermined time interval.
FIG. 8a shows an example of a drive current that is supplied to light-emitting panel 111 in which the supply time of the drive current is altered for each predetermined time interval.
FIG. 8b shows an example of drive current that is supplied to light-emitting panel 112 in which the supply time of the drive current is altered for each predetermined time interval.
FIG. 8c shows an example of drive current that is supplied to light-emitting panel 113 in which the supply time of the drive current is altered for each predetermined time interval.
FIG. 8d shows an example of drive current that is supplied to light-emitting panel 114 in which the supply time of the drive current is altered for each predetermined time interval.
FIG. 9a shows the drive voltage dependence characteristic of chromaticity of an organic EL element that has a characteristic whereby chromaticity decreases to the extent of the magnitude of the drive voltage.
FIG. 9b shows the drive voltage dependence characteristic of color temperature of the organic EL element shown in FIG. 9a.

### Best Mode for Carrying Out the Invention

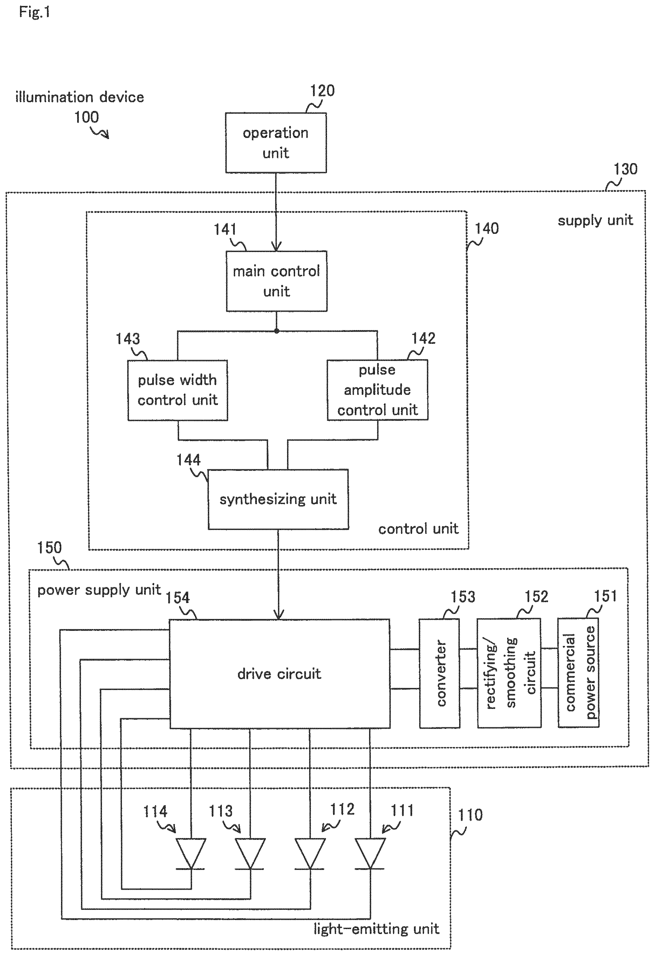

An exemplary embodiment of the present invention is next described with reference to the accompanying drawings. FIG. 1 is a block diagram showing an example of the configuration of the illumination device in the exemplary embodiment of the present invention.

Illumination device 100 is an organic EL illumination device that uses a plurality of organic EL elements as a light-emitting element. Illumination device 100 is provided with light-emitting unit 110, operation unit 120, and supply unit 130. Supply unit 130 is provided with control unit 140 and power supply unit 150. Control unit 140 is provided with main control unit 141, pulse amplitude control unit 142, pulse width control unit 143, and synthesizing unit 144. Power supply unit 150 is provided with commercial power source 151, rectifying/smoothing circuit 152, converter 153, and drive circuit 154.

Light-emitting unit 110 is provided with a plurality of light-emitting panels 111-114. Each of light-emitting panels 111-114 is of the same configuration. Each of light-emitting panels 111-114 is made up by organic EL elements. Each of light-emitting panels 111-114 is a current drive-type element and is an electroluminescent element.

Each of light-emitting panels 111-114 is made up of, for example, white organic EL elements. A white organic EL element simultaneously emits colored light of, for example, red (R), green (G), and blue (B) within the same element and has a plurality of light-emitting sites.

Each of light-emitting panels 111-114 emits light when a drive signal for driving (causing emission of light) the light-emitting panel is supplied from drive circuit 154. Each of light-emitting panels 111-114 has a characteristic by which chromaticity changes according to the magnitude of the amplitude of the drive signal. The drive signal is, for example, a voltage signal or a current signal. In the present exemplary embodiment, a voltage signal (hereinbelow referred to as "drive voltage") is used as a drive signal.

In the present exemplary embodiment, the luminance (i.e., the amount of luminous flux) of light-emitting panels 111-114 increases to the extent that the supply time per unit time interval of the drive voltage to the light-emitting panel lengthens. In addition, in each of light-emitting panels 111-114, chromaticity changes according to the magnitude of the drive voltage.

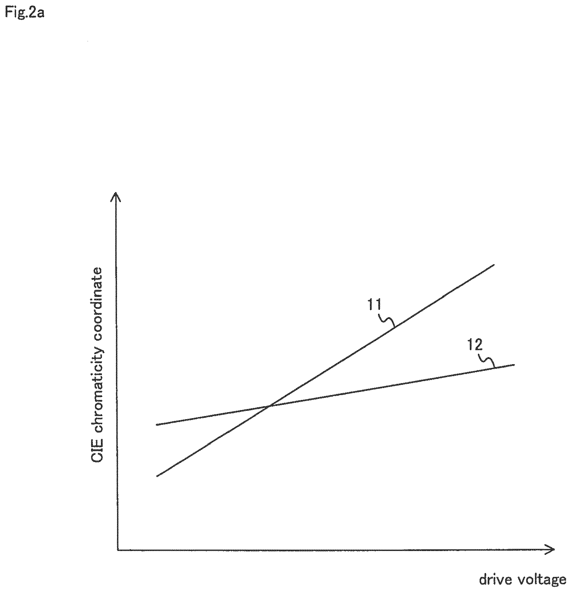

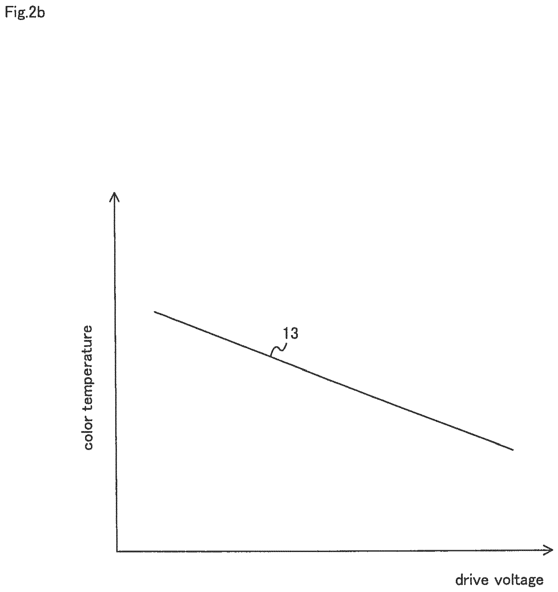

FIGs. 2a and 2b show examples of the drive voltage dependence characteristic of chromaticity and color temperature during light emission of light-emitting panel 111. In FIGs. 2a and 2b, each of light-emitting panels 111-114 is of the same configuration, and only light-emitting panel 111 is described.

FIG. 2a shows the correspondence relation between the drive voltage that is supplied to light-emitting panel 111 and the chromaticity of light-emitting panel 111. In FIG. 2a, chromaticity characteristic 11 of the x-coordinate and chromaticity characteristic 12 of the y-coordinate of the CIE (Commission International de l'Eclairage) chromaticity diagram are shown, the horizontal axis showing the magnitude of the drive voltage and the vertical axis showing the magnitude of the chromaticity of the x and y coordinates. As shown by chromaticity characteristics 11 and 12, in light-emitting panel 111, the chromaticity of the x coordinate and y coordinate of light-emitting panel 111 both increase according to increase in the drive voltage that is supplied to light-emitting panel 111.

FIG. 2b shows the drive voltage dependence characteristic of light-emitting panel 111 in which the chromaticity of light-emitting panel 111 shown in FIG. 2a is replaced by color temperature. FIG. 2b shows color temperature characteristic 13 with the horizontal axis showing the magnitude of the drive voltage and the vertical axis showing the magnitude of the color temperature. As shown by color temperature characteristic 13, in light-emitting panel 111, the color temperature of light-emitting panel 111 decreases according to increase of the drive voltage that is supplied to light-emitting panel 111.

Operation unit 120 can generally be referred to as a reception means.

Operation unit 120 receives, for each of light-emitting panels 111-114, chromaticity information that indicates the chromaticity of the relevant light-emitting panel and luminance information that indicates the luminance of the relevant light-emitting panel.

In the present exemplary embodiment, operation unit 120 is provided with, for each of light-emitting panels 111-114, a chromaticity adjustment button that is used for increasing or decreasing the magnitude of the drive voltage and a luminance adjustment button that is used for increasing or decreasing the supply time per unit time interval of the drive voltage to a light-emitting panel. Each of the chromaticity adjustment button and luminance adjustment button consist of an increase button and a decrease button.

Chromaticity information that indicates the chromaticity of light-emitting panels and luminance information that indicates the luminance of the light-emitting panels are applied as input to operation unit 120 by the manipulation of the chromaticity adjustment button and luminance adjustment button by the user of illumination device 100. Operation unit 120 therefore receives chromaticity information and luminance information for each of light-emitting panels 111-114.

For example, when the chromaticity of light-emitting panel 111 is lower than that of the other light-emitting panels 112-114, the user's pressing the increase button of the chromaticity adjustment button of light-emitting panel 111 causes operation unit 120 to receive chromaticity information for light-emitting panel 111 that indicates chromaticity that is greater than the chromaticity information that immediately preceded pressing the increase button.

Operation unit 120 further supplies chromaticity information and luminance information for each of light-emitting panels 111-114 to main control unit 141. For example, each time the chromaticity adjustment button or luminance adjustment button is pressed, operation unit 120 supplies to main control unit 141 the chromaticity information and luminance information of light-emitting panels 111 to 114 that are entered as input by the button that was pressed.

Supply unit 130 can typically be referred to as a supply means.

For each of light-emitting panels 111-114, supply unit 130 supplies to the relevant light-emitting panel a drive signal that has amplitude that accords with the chromaticity information for that light-emitting panel for, within a unit time interval, a time interval that accords with the luminance information for that light-emitting panel. Supply unit 130 increases the amplitude belonging to the drive signal to the extent of the magnitude of the chromaticity that is indicated by the chromaticity information. In addition, supply unit 130 lengthens the supply time interval of the unit time interval of supplying the drive signal to the light-emitting panel to the extent of the magnitude of the luminance indicated by the luminance information.

Control unit 140 uses the chromaticity information and luminance information for each of light-emitting panels 111-114 to control the pulse width and pulse amplitude of the drive signals that are supplied from drive circuit 154.

Main control unit 141 generates pulse signals and supplies these pulse signals to pulse amplitude control unit 142 and to pulse width control unit 143. The pulse signals are voltage signals or current signals. In the present exemplary embodiment, voltage signals are used as the pulse signals.

In addition, main control unit 141, upon receiving chromaticity information and luminance information of each of light-emitting panels 111-114 from operation unit 120, both supplies the chromaticity information of each of light-emitting panels 111-114 to pulse amplitude control unit 142 and supplies the luminance information of each of light-emitting panels 111-114 to pulse width control unit 143.

For each of light-emitting panels 111-114, pulse amplitude control unit 142 uses the chromaticity information for a relevant light-emitting panel to modulate the pulse signal that is supplied from main control unit 141. For each of light-emitting panels 111-114, pulse amplitude control unit 142 generates a pulse signal having amplitude that accords with the chromaticity indicated by the chromaticity information for the relevant light-emitting panel and supplies the pulse signal as an amplitude signal.

In the present exemplary embodiment, pulse amplitude control unit 142 increases the amplitude of the pulse signal for each of light-emitting panels 111-114 to the extent of the magnitude of the chromaticity that is indicated by the chromaticity information. In addition, pulse amplitude control unit 142 supplies amplitude signals that are generated for each of light-emitting panels 111-114 to synthesizing unit 144.

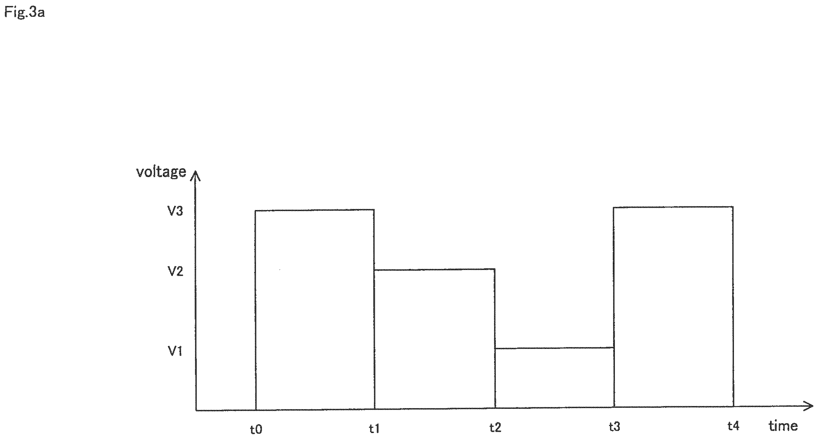

FIGs. 3a-3c are for describing signals that are generated in control unit 140. In FIGs. 3a-3c, examples are shown in which both luminance and chromaticity are successively adjusted for each predetermined time interval (unit time interval).

FIG. 3a shows by way of example the signal waveform of an amplitude signal that is supplied from pulse amplitude control unit 142. In addition, in FIG. 3a, the vertical axis shows voltage and the horizontal axis shows time.

In FIG. 3a, the amplitude signal is voltage V3 for a predetermined time interval from time t0 to t1, and voltage V2 for a predetermined time interval from time t1 to t2. Still further, the amplitude signal is voltage V1 for a predetermined time interval from time t2 to t3, and voltage V3 for a predetermined time interval from time t3 to t4.

Returning to FIG. 1, for each of light-emitting panels 111-114, pulse width control unit 143 uses the luminance information for a relevant light-emitting panel to modulate the pulse signal that is supplied from main control unit 141. Pulse width control unit 143 supplies, for each of light-emitting panels 111-114, a pulse signal for, within the unit time interval, a time interval that accords with the luminance that is indicated by the luminance information for that light-emitting panel.

For each of light-emitting panels 111-114, pulse width control unit 143 lengthens the output time interval of the pulse signal (hereinbelow referred to as a "periodic signal") that is supplied to synthesizing unit 144 within the unit time interval to the extent of the magnitude of the luminance indicated by the luminance information for that light-emitting panel. In addition, for each of light-emitting panels 111-114, pulse amplitude control unit 142 supplies to synthesizing unit 144 the periodic signal and output time that accord with the luminance indicated by the luminance information for that light-emitting panel.

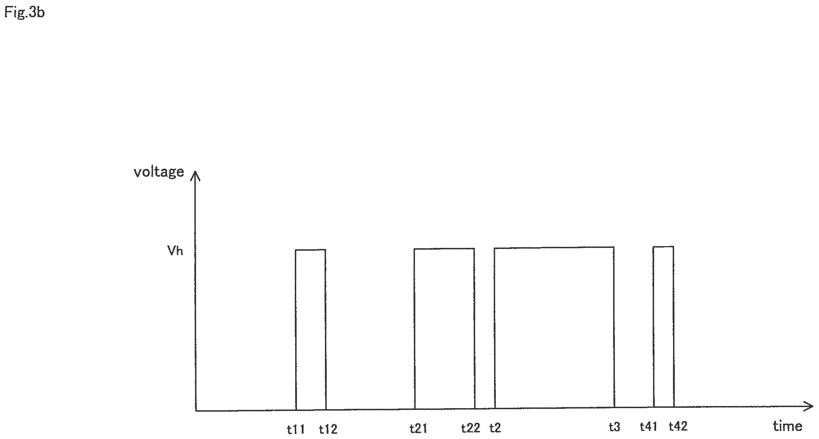

FIG. 3b shows by way of example the signal waveform of a periodic signal that is supplied from pulse width control unit 143. In FIG. 3b, the vertical axis is voltage and the horizontal axis is a time axis that is common to that of FIG. 3a. In FIG. 3b, voltage Vh that is greater than voltage V3 is shown.

In FIG. 3b, the periodic signal is voltage Vh for an output time interval from time t11 to t12 of a predetermined time interval, within from time t0 to t1, and is voltage Vh for an output time interval from time t21 to t22 of a predetermined time interval, within from time t1 to t2. In addition, the periodic signal is voltage Vh for an output time interval from time t2 to t3 of a predetermined time interval, within from time t2 to t3 and is voltage Vh for an output time interval from time t41 to t42 of a predetermined time interval, within from time t3 to t4.

Returning to FIG. 1, synthesizing unit 144 generates and supplies a synthesized signal by synthesizing the amplitude signal that is supplied from pulse amplitude control unit 142 and the periodic signal that is supplied from pulse width control unit 143.

In the present exemplary embodiment, synthesizing unit 144 synthesizes (superimposes) the amplitude signal that is supplied from pulse amplitude control unit 142 and the periodic signal that is supplied from pulse width control unit 143 for each of light-emitting panels 111-114. As a result, for each of light-emitting panels 111-114, synthesizing unit 144 supplies to drive circuit 154 a synthesized signal having an amplitude that accords with the chromaticity information for that light-emitting panel for, of the unit time interval, a time interval that accords with the luminance that is indicated by the luminance information for that light-emitting panel.

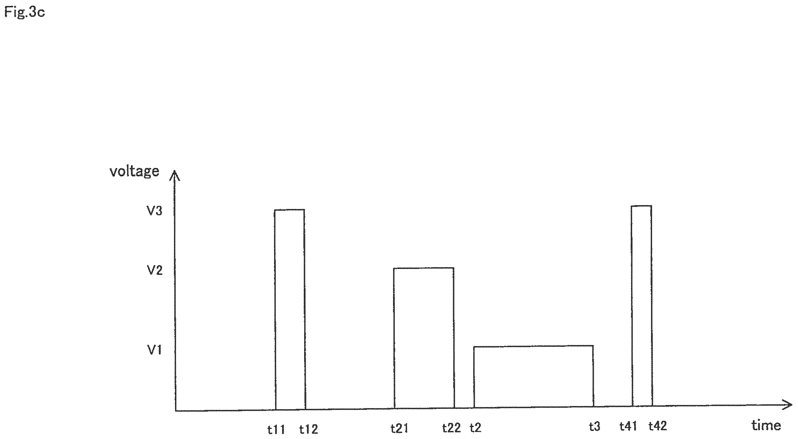

FIG. 3c shows by way of example the signal waveform of the synthesized signal that is supplied from synthesizing unit 144. In FIG. 3c, the vertical axis is voltage and the horizontal axis is the time axis that is common to FIG. 3a and FIG. 3b.

In FIG. 3c, the synthesized signal is voltage V3 for a time interval from time t11 to t12 of the predetermined time interval, within from time t0 to t1 and voltage V2 for a time interval from time t21 to t22 of the predetermined time interval, within from time t1 to t2. In addition, the synthesized signal is voltage V1 for a time interval from time t2 to t3 of the predetermined time interval, within from time t2 to t3 and voltage V3 for a time interval from time t41 to t42 of the predetermined time interval, within from time t3 to t4.

Thus, as shown in FIGs. 3a-3c, synthesizing unit 144 is able to simultaneously stipulate the pulse width and pulse amplitude of the synthesized signals by synthesizing amplitude signals and periodic signals.

Power supply unit 150, upon receiving the synthesized signals from synthesizing unit 144, generates drive signals based on the synthesized signals. Power supply unit 150 supplies these drive signals to light-emitting unit 110.

Commercial power source 151 is a commercial alternating current power supply. Commercial power source 151 supplies an alternating current (AC) voltage of 50 or 60 Hertz (Hz) and 100 volts (V) to rectifying/smoothing circuit 152.

Rectifying/smoothing circuit 152 subjects the alternating current voltage that is supplied from commercial power source 151 to full-wave rectification. Rectifying/smoothing circuit 152 is made of, for example, a diode bridge that has four diodes.

Rectifying/smoothing circuit 152 smoothes the voltage that has undergone full-wave rectification. For example, rectifying/smoothing circuit 152 uses an RC circuit to make the full-wave rectified voltage a direct-current voltage. Rectifying/smoothing circuit 152 supplies this direct-current voltage to converter 153.

Converter 153 is a DC (Direct Current)/DC converter. Converter 153 steps down the direct-current voltage that is supplied from rectifying/smoothing circuit 152 to a specific direct-current voltage. Converter 153 is made up of, for example, a step-down chopper circuit. Converter 153 supplies the stepped-down direct-current voltage to drive circuit 154.

Drive circuit 154 is supplied the specific direct-current voltage from converter 153 as the power-source voltage. In addition, drive circuit 154 receives each of the synthesized signals of light-emitting panels 111-114 from synthesizing unit 144.

Drive circuit 154, upon receiving each of the synthesized signals of light-emitting panels 111-114 from synchronizing unit 144, generates a drive voltage based on the synthesized signal for each of light-emitting panels 111-114. Drive circuit 154 amplifies each of the synthesized signals of light-emitting panels 111-114 by a predetermined multiplying factor and supplies the amplified synthesized signals as the drive voltages to light-emitting panels 111-114.

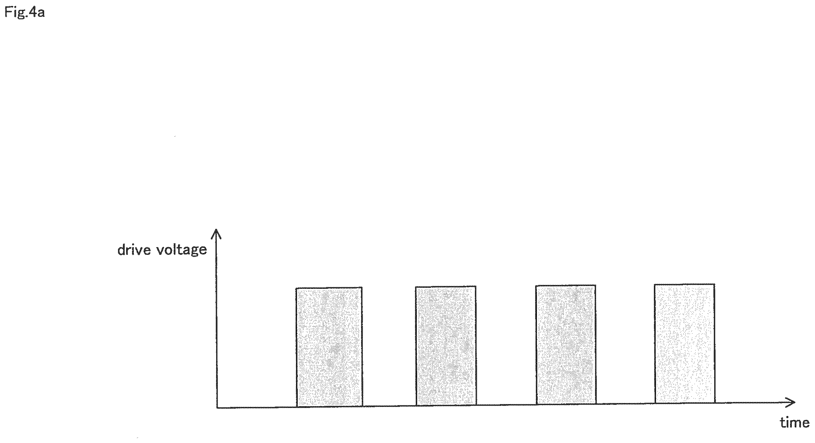

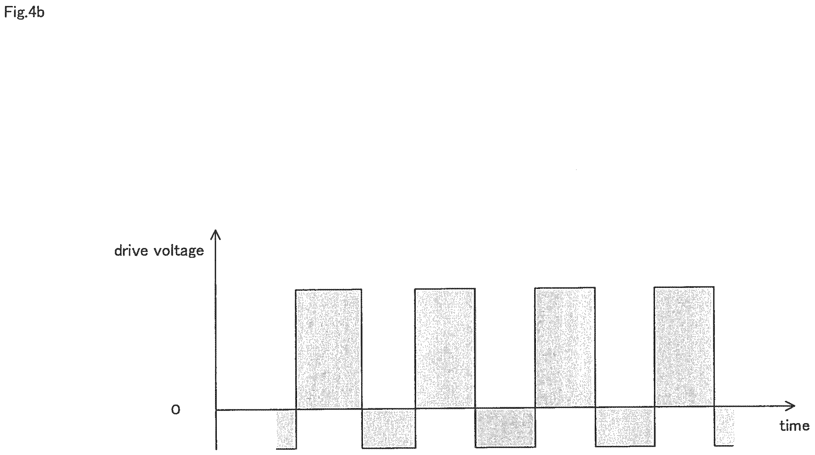

FIGs. 4a and 4b show examples of the waveform of the drive voltage that is supplied from drive circuit 154 to light-emitting panel 111. In FIG. 4, the vertical axis is the magnitude of the drive voltage and the horizontal axis is time.

FIG. 4a shows the waveform of the drive voltage following adjustment of both the magnitude of the drive voltage and the supply time of the drive voltage per unit time.

FIG. 4b shows a waveform that differs from the waveform of the drive voltage shown in FIG. 4a. In FIG. 4b, drive circuit 154 supplies to light-emitting panel 111 a voltage of polarity that differs from the drive voltage (reverse bias voltage) at the time of non-emission of light-emitting panel 111, whereby the electrostatic charge of light-emitting panel 111 can be reduced and the operation life of light-emitting panel 111 can be extended.

Upon receiving the synthesized signals of each of light-emitting panels 111-114, drive circuit 154 may generate current signals (hereinbelow referred to as "drive current") based on these synthesized signals. For example, Field-Effect Transistors (FET) that are connected in series to each of light-emitting panels 111-114 are used in drive circuit 154. The output terminal of synthesizing unit 144 is connected to the gate terminal of the FET of light-emitting panel 111 and the input terminal of light-emitting panel 111 is connected to the source terminal. In this case, drive circuit 154 supplies the synthesized signal of light-emitting panel 111 to the gate terminal of the FET that is connected to light-emitting panel 111. As a result, a drive current that accords with the synthesized signal is supplied to light-emitting panel 111 from the source terminal of the FET that is connected to light-emitting panel 111.

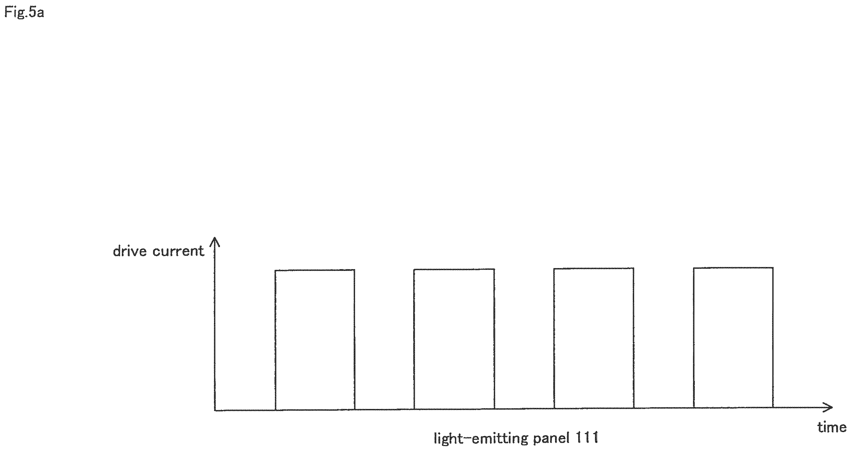

FIGs. 5a-5d show examples of the waveform of the drive current that is supplied to each of light-emitting panels 111-114 after adjusting for variations in chromaticity and luminance. In FIGs. 5a-5d, the vertical axis shows the magnitude of the drive current and the horizontal axis shows time.

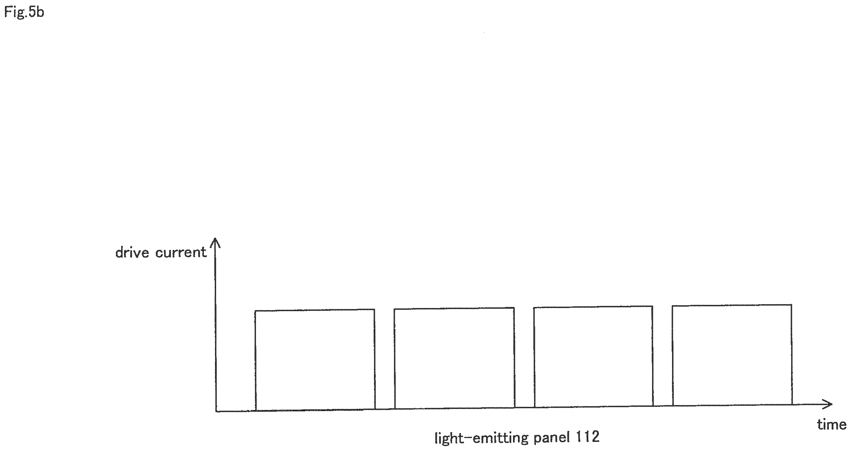

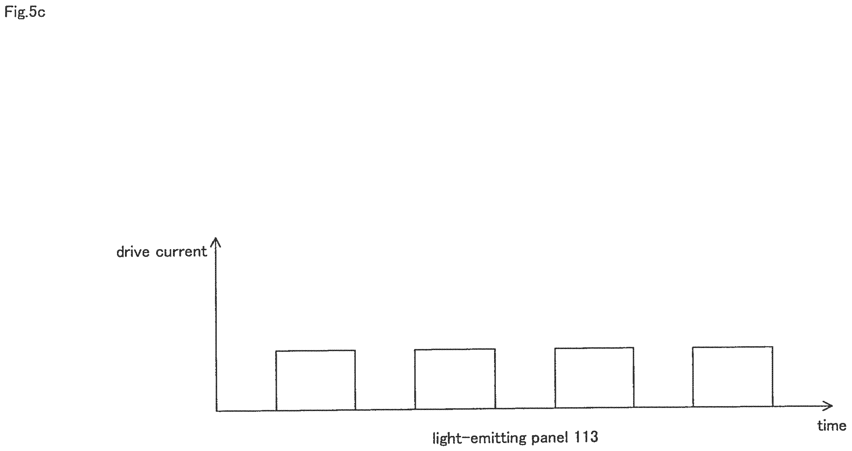

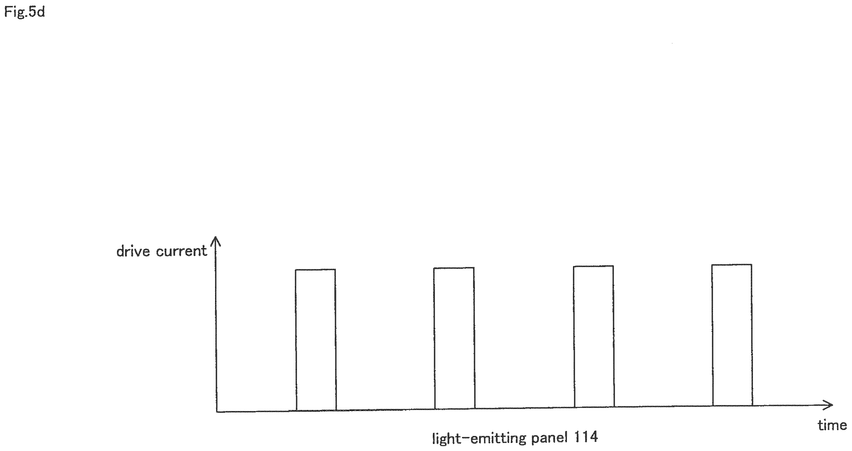

FIG. 5a is the waveform of the drive current that is supplied to light-emitting panel 111. FIG. 5b is the waveform of the drive current that is supplied to light-emitting panel 112. FIG. 5c is the waveform of the drive current that is supplied to light-emitting panel 113. FIG. 5d is the waveform of the drive current that is supplied to light-emitting panel 114.

As shown in FIGs. 5a-5d, in illumination device 100, the magnitude of the drive current and the supply time of the drive current per unit time interval can be simultaneously adjusted for each of light-emitting panels 111-114, whereby variations in the luminance and chromaticity among the light-emitting panels can be suppressed.

The operation of illumination device 100 is next described.

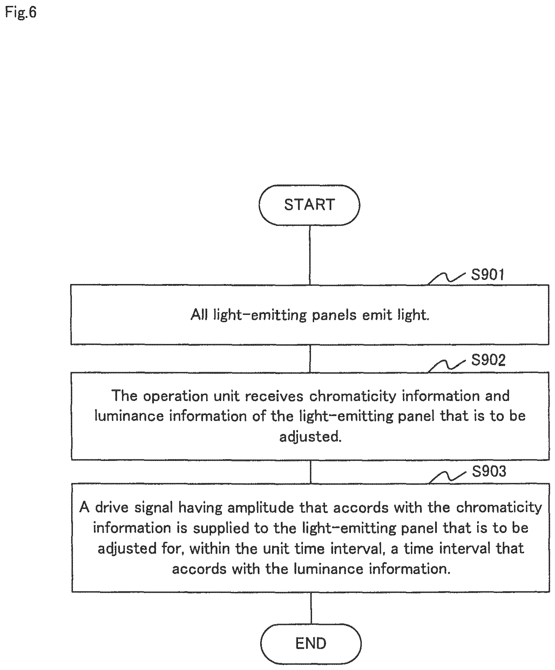

FIG. 6 is a flow chart showing the processing procedures of the light-adjusting method in illumination device 100.

First, upon receiving drive signals that are supplied from power supply unit 150, light-emitting panels 111-114 each emit light (Step S901).

A case is assumed in which, when light-emitting panels 111-114 each emit light, the luminance and chromaticity of light-emitting panel 111 differ from the other light-emitting panels 112-114. As a result, the user of illumination device 100 enters chromaticity information and luminance information of light-emitting panel 111, and operation unit 120 receives the chromaticity information and luminance information for light-emitting panel 111 (Step S902).

When operation unit 120 receives the chromaticity information and luminance information for light-emitting panel 111, supply unit 130 supplies to light-emitting panel 111 a drive signal having amplitude that accords with the chromaticity indicated by the chromaticity information for light-emitting panel 111 for, of the unit time interval, a time interval that accords with the luminance indicated by the luminance information for light-emitting panel 111 (Step S903), whereby the series of processing procedures of the light-adjusting method is completed.

According to the present exemplary embodiment, illumination device 100 has a plurality of light-emitting panels 111-114 as an organic EL element, and operation unit 120 receives chromaticity information that indicates the chromaticity of the light-emitting panels and luminance information that indicates the luminance of the light-emitting panels for each of light-emitting panels 111-114. Supply unit 130 then supplies, for each of light-emitting panels 111-114, a drive signal having amplitude that accords with the chromaticity indicated by the chromaticity information for that light-emitting panel to that light-emitting panel for, of the unit time interval, a time interval that accords with the luminance indicated by that luminance information.

As a result, illumination device 100 is able to, during light emission, both reduce variations in chromaticity among light-emitting panels 111-114 and reduce variations in luminance among light-emitting panels 111-114.

As a result, illumination device 100 is able to correct the luminance and chromaticity of light-emitting panels for each of light-emitting panels 111-114 even when variations occur in the luminance and chromaticity among light-emitting panels 111-114 due to errors in the fabrication processes of light-emitting unit 110. Variations in luminance and chromaticity during light emission among light-emitting panels 111-114 can thus be suppressed.

In addition, illumination device 100 is able to adjust variations in luminance and chromaticity among light-emitting panels 111-114 even when variations occur in luminance and chromaticity among light-emitting panels 111-114 due to change in the luminance characteristic and chromaticity characteristic of each of light-emitting panels 111-114 due to deterioration of each of light-emitting panels 111-114.

In addition, in the present exemplary embodiment, supply unit 130 increases the amplitude of the drive signal to the extent of the magnitude of the chromaticity indicated by the chromaticity information. As a result, illumination device 100 is able to adjust the chromaticity of each of light-emitting panels 111-114 by changing the amplitude of the drive signal of each of light-emitting panels 111-114.

In the present exemplary embodiment, supply unit 130 lengthens, within the unit time interval, the time interval in which the drive signal is supplied to a light-emitting panel to the extent of the magnitude of the luminance indicated by the luminance information. As a result, illumination device 100 is able to adjust the luminance of each of light-emitting panels 111-114 by changing, within the unit time interval, the time interval in which the drive signal is supplied to the light-emitting panel.

When variations in luminance and chromaticity are great among light-emitting panels in an illumination device that lacks the capability to adjust luminance and chromaticity of light-emitting panels, all of the light-emitting panels must be exchanged. In contrast, illumination device 100 in the exemplary embodiment of the present invention is able to individually adjust the luminance and chromaticity of light-emitting panels for each of light-emitting panels 111-114, whereby all light-emitting panels 111-114 need not be exchanged. As a result, the running costs of illumination device 100 can be limited.

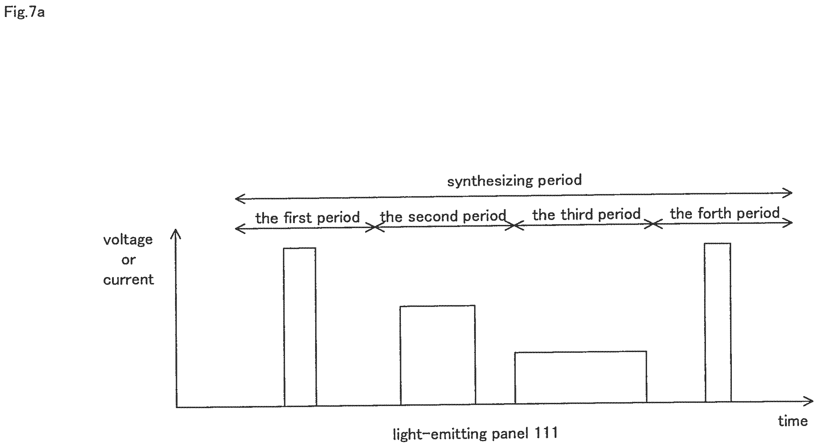

FIGs. 7a-7d are views for describing modifications of the light-adjusting method of illumination device 100. FIGs. 7a-7d show first to fourth periods, respectively, that are assigned within a synthesizing period. The period of the first to fourth periods (i.e., the period of a pulse signal that is generated in main control unit 141) is assumed to be set to at least 50 Hz. In FIGs. 7a-7d, the vertical axis shows the magnitude of a drive signal and the horizontal axis shows time.

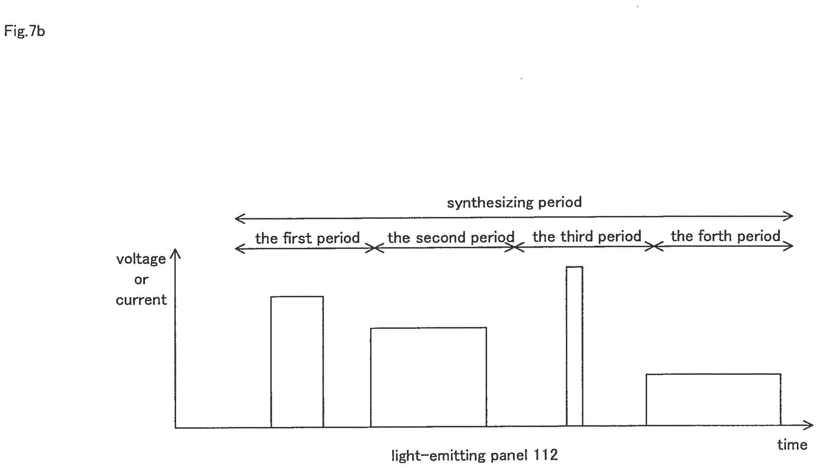

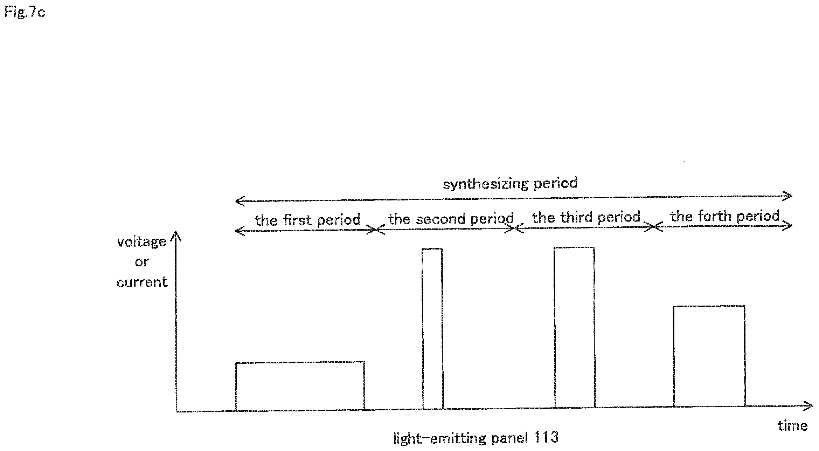

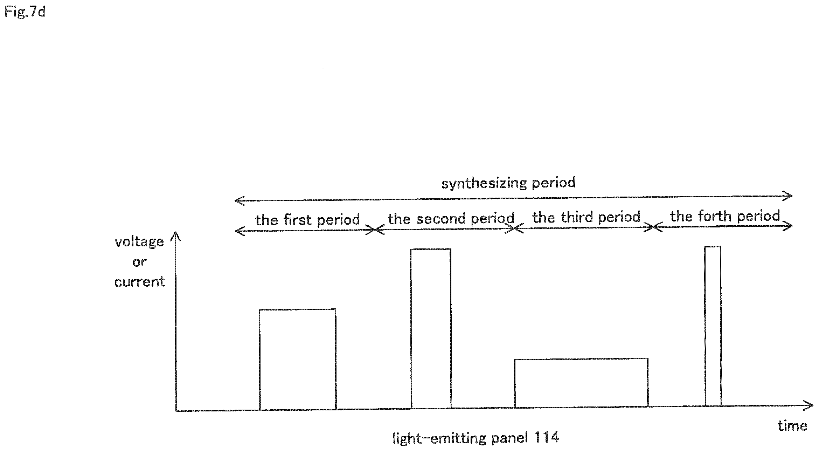

FIG. 7a is the waveform of the drive signal that is supplied to light-emitting panel 111. FIG. 7b is the waveform of the drive signal that is supplied to light-emitting panel 112. FIG. 7c is the waveform of the drive signal that is supplied to light-emitting panel 113. FIG. 7d is the waveform of the drive signal that is supplied to light-emitting panel 114.

In FIGs. 7a-7b, operation unit 120 receives chromaticity information and luminance information for each of a plurality of specific intervals (first to fourth intervals) in the unit time interval (synthesizing period) for each of light-emitting panels 111-114. Supply unit 130 then, for the specific interval of each of light-emitting panels 111-114, supplies to the relevant light-emitting panel a drive signal having amplitude that accords with the chromaticity information for the specific interval for a time interval that accords with the luminance information for that specific interval.

For example, in FIG. 7a, operation unit 120 receives chromaticity information and luminance information for each of the first to fourth intervals within the synthesizing period of light-emitting panel 111. Supply unit 130 then, in the first interval of light-emitting panel 111, supplies a drive signal having amplitude that accords with the chromaticity information for the first interval to light-emitting panel 111 for a time interval that accords with the luminance information for that first interval. Supply unit 130 further, in the second interval of light-emitting panel 111, supplies a drive signal having amplitude that accords with the chromaticity information for the second interval to light-emitting panel 111 for a time interval that accords with the luminance information for that second interval.

Still further, in the third interval of light-emitting panel 111, supply unit 130 supplies a drive signal having amplitude that accords with the chromaticity information for the third interval to light-emitting panel 111 for a time interval that accords with the luminance information for that third interval. Then, in the fourth interval of light-emitting panel 111, supply unit 130 supplies a drive signal having amplitude that accords with the chromaticity information for the fourth interval to light-emitting panel 111 for a time interval that accords with the luminance information for that fourth interval.

As a result, in the light-adjusting method shown in FIG. 7, each of light-emitting panels 111-114 emits light at a luminance and chromaticity that differs for each of the first to fourth intervals of the synthesizing period. At this time, the light of each of light-emitting panels 111-114 in the first to fourth intervals is recognized as synthesized light by the human eye.

As a result, changing the amplitude and supply time of the drive signal in each of the first to fourth intervals enables change of the luminance and chromaticity of each of light-emitting panels 111-114 that is perceived by the human eye. Because the amplitude and supply time of the drive signal can be adjusted in each of the intervals of the first to fourth intervals, the adjustment range of, for example, the chromaticity of light-emitting panels 111-114 can be extended.

In addition, regular supply of drive signals in organic EL elements that make up light-emitting panels 111-114 hastens the deterioration of the organic material and tends to increase the deterioration of luminance of the organic EL elements. In the light-adjusting method shown in FIG. 7, drive signals of mutually differing amplitude can be supplied to each of light-emitting panels 111-114 for mutually differing time intervals for each of the first to fourth intervals. As a result, deterioration of the luminance of each of light-emitting panels 111-114 can be suppressed, and the increase of drive voltage that is caused by deterioration in luminance can be reduced. As a result, illumination device 100 can limit power consumption.

In FIGs. 7a-7d, an example was described in which the amplitude and supply time of drive signals were changed in each of first to fourth intervals, but either the amplitude or supply time may be changed in each of the first to fourth intervals. An illumination device in which either the amplitude or supply time of a drive signal is changed is also able to reduce the regularity of drive signals that, are supplied to each of light-emitting panels 111-114. As a result, luminance deterioration of each of light-emitting panels 111-114 can be suppressed.

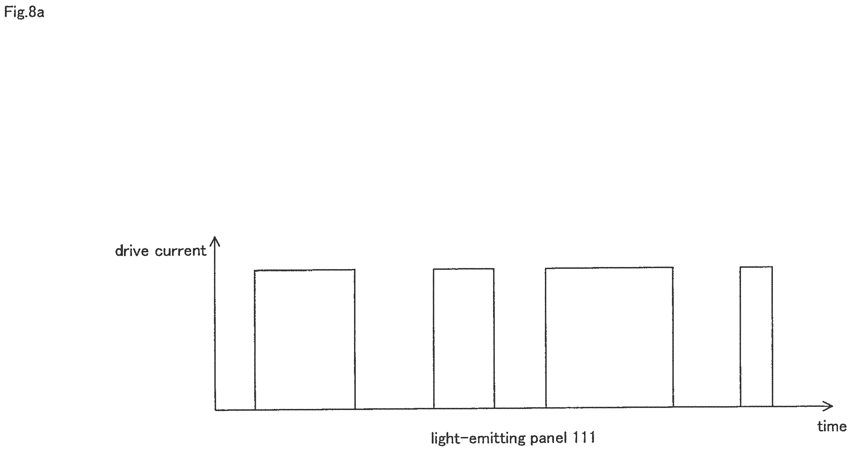

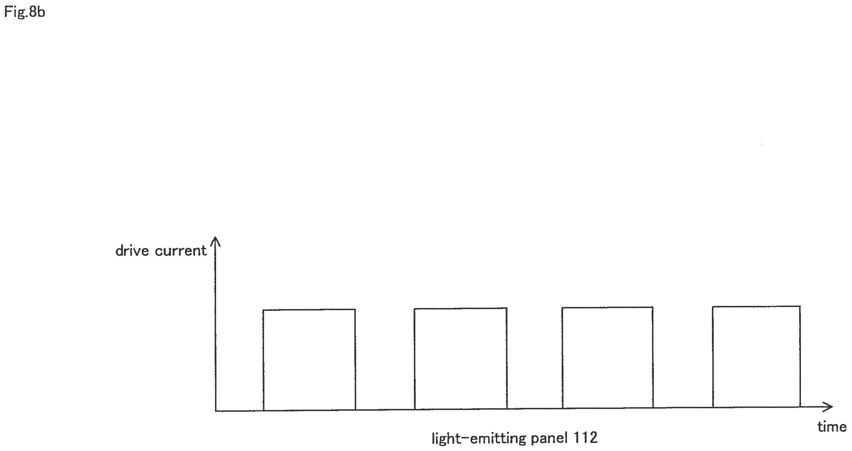

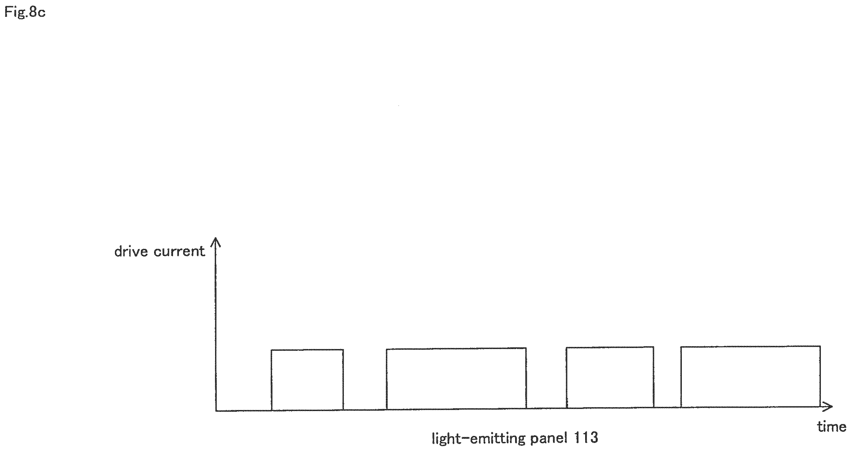

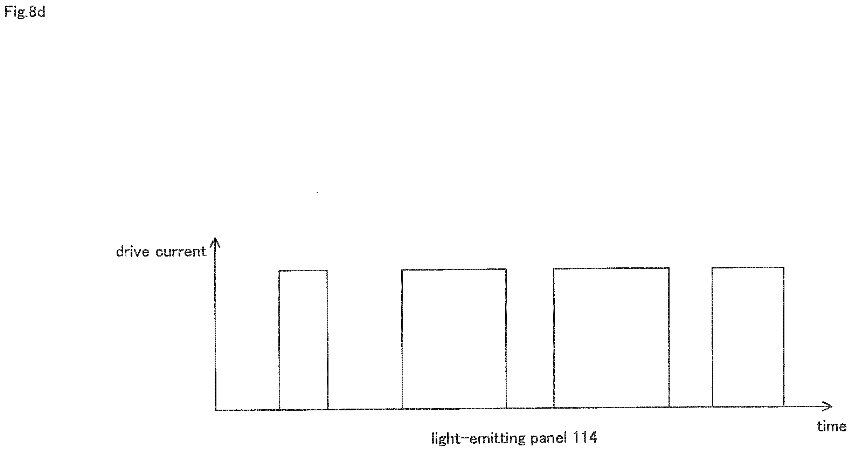

FIGs. 8a-8d show examples in which only the supply time of the drive current is changed in the synthesizing period. FIG. 8a shows the waveform of the drive current that is supplied to light-emitting panel 111. FIG. 8b shows the waveform of the drive current that is supplied to light-emitting panel 112. FIG. 8c shows the waveform of the drive current that is supplied to light-emitting panel 113. FIG. 8d shows the waveform of the drive current that is supplied to light-emitting panel 114.

In FIGs. 8a-8d, changing the supply time of the drive current for each of the first to fourth periods results in a greater decrease of the regularity of the drive current that is supplied to light-emitting panels 111-114 compared to FIGs. 5a-5d. In addition, because the speed of deterioration differs for each of light-emitting panels 111-114, the supply time of the drive current is different.

The exemplary embodiment of the present invention can be applied to, for example, the backlight of a liquid crystal display.

Although explanation in the present exemplary embodiment regards light-emitting panels 111-114 that have the characteristic that chromaticity decreases to the extent of the increase of the drive voltage, there are also organic EL elements in which, through change of the element configuration or the material of the organic EL elements that make up light-emitting panels 111-114, have the property that chromaticity decreases to the extent that the drive voltage increases

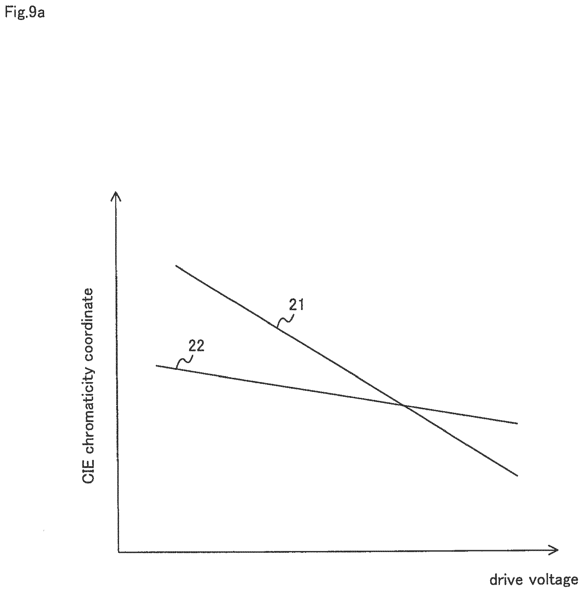

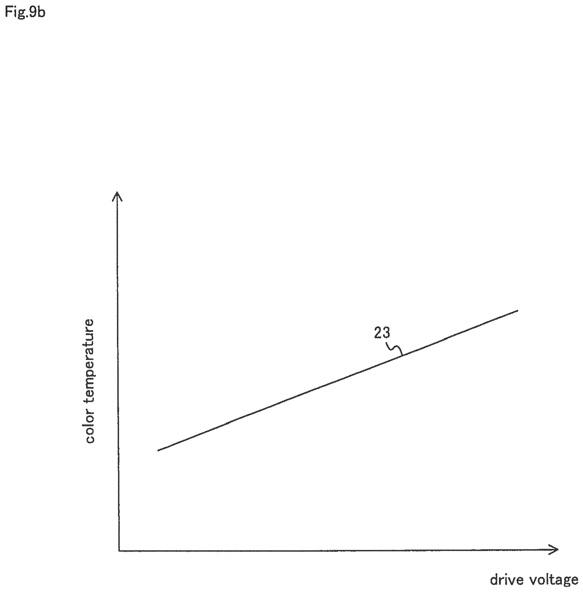

FIGs. 9a and 9b show examples of the drive voltage dependency characteristic of the chromaticity and color temperature of an organic EL element that has the characteristic by which chromaticity decreases to the extent that the drive voltage increases.

FIG. 9a shows the correspondence relation between the chromaticity of an organic EL element and the drive voltage that is supplied to the organic EL element. FIG. 9a shows the chromaticity characteristic of the x-coordinate and the chromaticity characteristic of the y-coordinate of the CIE chromaticity diagram, the horizontal axis showing the magnitude of the drive voltage and the vertical axis showing the magnitude of the chromaticity of the x and y coordinates. As shown by the chromaticity characteristics 21 and 22, the chromaticity of both the x-coordinate and y-coordinate of an organic EL element decreases to the extent that the magnitude of the drive voltage supplied to the organic EL element increases.

FIG. 9b shows the drive voltage dependency characteristic of an organic EL element in which color temperature replaces the chromaticity of the organic EL element shown in FIG. 9a. FIG. 9b shows color temperature characteristic 23 with the horizontal axis showing the magnitude of the drive voltage and the vertical axis showing the magnitude of the color temperature. As shown by color temperature characteristic 23, the color temperature of an organic EL element increases to the extent that the drive voltage that is supplied to the organic EL element increases.

In the present exemplary embodiment, organic EL elements having the characteristics shown in FIGs. 9a and 9b may be used as the light-emitting panels of illumination device 100. In this case, supply unit 130 decreases the amplitude belonging to the drive signal to the extent of the magnitude of the chromaticity shown by chromaticity information. In this way, variations in the chromaticity of each light-emitting panel can be adjusted.

### Explanation of Reference Numbers

- 100: illumination device
- 110: light-emitting unit
- 111-114: light-emitting panels
- 120: operation unit
- 130: supply unit
- 140: control unit
- 141: main control unit
- 142: pulse amplitude control unit
- 143: pulse width control unit
- 144: synthesizing unit
- 150: power supply unit
- 151: commercial power source
- 152: rectifying/smoothing circuit
- 153: converter
- 154: drive circuit

## Claims

1. An illumination device (100) comprising:
a plurality of organic EL elements (111-114);
reception means (120) that receives, for each of said organic EL elements, chromaticity information that indicates the chromaticity of the relevant organic EL element and luminance information that indicates the luminance of the relevant organic EL element; and
supply means (154) that, for each of said organic EL elements (111-114), supplies to the relevant organic EL element a drive signal having an amplitude that accords with the chromaticity that was indicated by the chromaticity information for that organic EL element for, within a unit time interval, a time interval that accords with the luminance indicated by the luminance information for that organic EL element, **characterized in that**
said supply means is arranged to time-divide said unit time interval into a plurality of specific intervals, and to supply said drive signal to said organic EL elements such that the amplitude or the supplying time of said drive signals are different in each specific interval.

2. The illumination device (100) as set forth in claim 1, wherein said supply means increases amplitude of said drive signal to the extent of the magnitude of chromaticity indicated by said chromaticity information.

3. The illumination device (100) as set forth in claim 1, wherein said supply means (154) decreases amplitude of said drive signal to the extent of the magnitude of chromaticity indicated by said chromaticity information.

4. The illumination device (100) as set forth in any one of claims 1 to 3, wherein said supply means (154) lengthens the time interval of supplying to said organic EL element said drive signal, within said unit time interval, to the extent of the magnitude of luminance indicated by said luminance information.

5. A light-adjusting method in an illumination device (100) that has a plurality of organic EL elements (111-114), comprising steps of:
receiving, for each of said organic EL elements (111-114), chromaticity information that indicates chromaticity of a relevant organic EL element and luminance information that indicates luminance of the relevant organic EL element; and
for each of said organic EL elements, supplying to the relevant organic EL element a drive signal having amplitude that accords with the chromaticity that was indicated by the chromaticity information for the relevant organic EL element for, within a unit time interval, a time interval that accords with the luminance indicated by the luminance information for the relevant organic EL element and **characterized by**
time-dividing said unit time interval into a plurality of specific intervals; and
supplying said drive signal to said organic EL elements such that the amplitude or the supplying time of said drive signals are different in each specific interval.

6. The light-adjusting method as set forth in claim 5, wherein supplying said drive signal to said organic EL element includes increasing amplitude of said drive signal to the extent of the magnitude of chromaticity indicated by said chromaticity information.

7. The light-adjusting method as set forth in claim 5, wherein supplying said drive signal to said organic EL element includes decreasing amplitude of said drive signal to the extent of the magnitude of chromaticity indicated by said chromaticity information.

8. The light-adjusting method as set forth in any one of claims 5 to 7, wherein supplying said drive signal to said organic EL element includes lengthening, within said unit time interval, the time interval of supplying said drive signal to said organic EL element to the extent of the magnitude of luminance indicated by said luminance information.

## Patentansprüche

1. Beleuchtungsgerät (100), das Folgendes umfasst:
mehrere organische EL-Elemente (111-114);
ein Empfangsmittel (120), das für jedes der genannten organischen EL-Elemente Chromatizitätsinformationen, die die Chromatizität des relevanten organischen EL-Elements anzeigen, und Luminanzinformationen empfängt, die die Luminanz des relevanten organischen EL-Elements anzeigen; und
ein Anlegemittel (154), das für jedes der genannten organischen EL-Elemente (111-114) ein Ansteuerungssignal an das relevante organische EL-Element mit einer Amplitude anlegt, die mit der Chromatizität in Einklang steht, die durch die Chromatizitätsinformationen für dieses organische EL-Element für, innerhalb eines Einheitszeitintervalls, ein Zeitintervall anzeigt wurde, das mit der Luminanz in Einklang steht, die durch die Luminanzinformationen für dieses organische EL-Element angezeigt wurde, **dadurch gekennzeichnet, dass**
das genannte Anlegemittel zum zeitlichen Unterteilen des genannten Einheitszeitintervalls in mehrere spezifische Intervalle und zum Anlegen des genannten Ansteuerungssignals an die genannten organischen EL-Elemente ausgelegt ist, so dass die Amplitude oder die Anlegezeit der genannten Ansteuerungssignale in jedem spezifischen Intervall unterschiedlich sind.

2. Beleuchtungsgerät (100) nach Anspruch 1, wobei das genannte Anlegemittel die Amplitude des genannten Ansteuerungssignals im Ausmaß der durch die genannten Chromatizitätsinformationen angezeigten Chromatizitätsgröße erhöht.

3. Beleuchtungsgerät (100) nach Anspruch 1, wobei das genannte Anlegemittel (154) die Amplitude des genannten Ansteuerungssignals im Ausmaß der durch die genannten Chromatizitätsinformationen angezeigten Chromatizitätsgröße verringert.

4. Beleuchtungsgerät (100) nach einem der Ansprüche 1 bis 3, wobei das genannte Anlegemittel (154) das Zeitintervall des Anlegens des genannten Ansteuerungssignals an das genannte organische EL-Element innerhalb des genannten Einheitszeitintervalls auf das Ausmaß der durch die genannten Luminanzinformationen angezeigten Luminanzgröße verlängert.

5. Lichteinstellverfahren in einem Beleuchtungsgerät (100), das mehrere organische EL-Elemente (111-114) aufweist, das die folgenden Schritte beinhaltet:
Empfangen, für jedes der genannten organischen EL-Elemente (111-114), von Chromatizitätsinformationen, die Chromatizität eines relevanten organischen EL-Elements anzeigen, und von Luminanzinformationen, die Luminanz des relevanten organischen EL-Elements anzeigen; und
Anlegen eines Ansteuerungssignals, für jedes der genannten organischen EL-Elemente, an das relevante organische EL-Element, mit einer Amplitude, die mit der Chromatizität in Einklang steht, die durch die Chromatizitätsinformationen für das relevante organische EL-Element für, innerhalb eines Einheitszeitintervalls, ein Zeitintervall angezeigt wurde, das mit der Luminanz in Einklang steht, die durch die Luminanzinformationen für das relevante organische EL-Element angezeigt wurde, und **gekennzeichnet durch**
zeitliches Unterteilen des genannten Einheitszeitintervalls in mehrere spezifische Intervalle; und
Anlegen des genannten Ansteuerungssignals an die genannten organischen EL-Elemente, so dass die Amplitude oder die Anlegezeit der genannten Ansteuerungssignale in jedem spezifischen Intervall unterschiedlich ist.

6. Lichteinstellverfahren nach Anspruch 5, wobei das Anlegen des genannten Ansteuerungssignals an das genannte organische EL-Element das Erhöhen der Amplitude des genannten Ansteuerungssignals im Ausmaß der durch die genannten Chromatizitätsinformationen angezeigten Chromatizitätsgröße beinhaltet.

7. Lichteinstellverfahren nach Anspruch 5, wobei das Anlegen des genannten Ansteuerungssignals an das genannte organische EL-Element das Verringern der Amplitude des genannten Ansteuerungssignals im Ausmaß der durch die genannten Chromatizitätsinformationen angezeigten Chromatizitätsgröße beinhaltet.

8. Lichteinstellverfahren nach einem der Ansprüche 5 bis 7, wobei das Anlegen des genannten Ansteuerungssignals an das genannte organische EL-Element das Verlängern, innerhalb des genannten Einheitszeitintervalls, des Zeitintervalls des Anlegens des genannten Ansteuerungssignals an das genannte organische EL-Element im Ausmaß der durch die genannten Luminanzinformationen angezeigten Luminanzgröße beinhaltet.

## Revendications

1. Dispositif d'éclairage (100) comprenant :
une pluralité d'éléments EL organiques (111-114) ;
un moyen de réception (120) qui reçoit, pour chacun desdits éléments EL organiques, des informations de chromaticité qui indiquent la chromaticité de l'élément EL organique pertinent et des informations de luminance qui indiquent la luminance de l'élément EL organique pertinent ; et
un moyen de fourniture (154) qui, pour chacun desdits éléments EL organiques (111-114), fournit à l'élément EL organique pertinent un signal d'attaque ayant une amplitude en accord avec la chromaticité indiquée par les informations de chromaticité pour cet élément EL organique pendant, dans les limites d'un intervalle de temps unitaire, un intervalle de temps en accord avec la luminance indiquée par les informations de luminance pour cet élément EL organique, **caractérisé en ce que**
ledit moyen de fourniture est agencé pour diviser dans le temps ledit intervalle de temps unitaire en une pluralité d'intervalles spécifiques, et fournir ledit signal d'attaque auxdits éléments EL organiques de telle sorte que l'amplitude ou le temps de fourniture desdits signaux d'attaque soit différent dans chaque intervalle spécifique.

2. Dispositif d'éclairage (100) selon la revendication 1, dans lequel ledit moyen d'alimentation augmente l'amplitude dudit signal d'attaque en fonction de la grandeur de chromaticité indiquée par lesdites informations de chromaticité.

3. Dispositif d'éclairage (100) selon la revendication 1, dans lequel ledit moyen d'alimentation (154) diminue l'amplitude dudit signal d'attaque en fonction de la grandeur de chromaticité indiquée par lesdites informations de chromaticité.

4. Dispositif d'éclairage (100) selon l'une quelconque des revendications 1 à 3, dans lequel ledit moyen d'alimentation (154) rallonge l'intervalle de temps d'alimentation dudit signal d'attaque audit élément EL organique, dans ledit intervalle de temps unitaire, en fonction de la grandeur de luminance indiquée par lesdites informations de luminance.

5. Procédé de réglage de lumière dans un dispositif d'éclairage (100) qui présente une pluralité d'éléments EL organiques (111-114), comprenant des étapes de :
réception, pour chacun desdits éléments EL organiques (111-114), d'informations de chromaticité qui indiquent la chromaticité d'un élément EL organique pertinent et d'informations de luminance qui indiquent la luminance de l'élément EL organique pertinent ; et
pour chacun desdits éléments EL organiques, la fourniture à l'élément EL organique pertinent d'un signal d'attaque ayant une amplitude en accord avec la chromaticité indiquée par les informations de chromaticité pour l'élément EL organique pertinent pendant, dans les limites d'un intervalle de temps unitaire, un intervalle de temps en accord avec la luminance indiquée par les informations de luminance pour l'élément EL organique pertinent et **caractérisé par**
la division dans le temps dudit intervalle de temps unitaire en une pluralité d'intervalles spécifiques ; et
la fourniture dudit signal d'attaque auxdits éléments EL organiques de telle sorte que l'amplitude ou le temps de fourniture desdits signaux d'attaque soit différent dans chaque intervalle spécifique.

6. Procédé de réglage de lumière selon la revendication 5, dans lequel la fourniture dudit signal d'attaque audit élément EL organique comporte l'augmentation de l'amplitude dudit signal d'attaque en fonction de la grandeur de chromaticité indiquée par lesdites informations de chromaticité.

7. Procédé de réglage de lumière selon la revendication 5, dans lequel la fourniture dudit signal d'attaque audit élément EL organique comporte la diminution de l'amplitude dudit signal d'attaque en fonction de la grandeur de chromaticité indiquée par lesdites informations de chromaticité.

8. Procédé de réglage de lumière selon l'une quelconque des revendications 5 à 7, dans lequel la fourniture dudit signal d'attaque audit élément EL organique comporte le rallongement, dans ledit intervalle de temps unitaire, de l'intervalle de temps de fourniture dudit signal d'attaque audit élément EL organique en fonction de la grandeur de luminance indiquée par lesdites informations de luminance.
